Europäisches Patentamt

European Patent Office

Office européen des brevets

(19)

(11) Numéro de publication: **0 159 214**
**B1**

(12) **FASCICULE DE BREVET EUROPEEN**

(45) Date de publication du fascicule du brevet: **04.07.90**

(51) Int. Cl.⁵: **H 01 J 37/24,** H 01 J 37/315

(21) Numéro de dépôt: **85400367.0**

(22) Date de dépôt: **27.02.85**

(54) **Installation pour le travail des métaux par faisceau d'électrons.**

(30) Priorité: **23.03.84 FR 8404559**

(43) Date de publication de la demande:
**23.10.85 Bulletin 85/43**

(45) Mention de la délivrance du brevet:
**04.07.90 Bulletin 90/27**

(84) Etats contractants désignés:
**AT BE CH DE GB IT LI SE**

(56) Documents cités:
**FR-A-2 456 384**
**FR-A-2 533 070**
**GB-A-2 081 941**

(73) Titulaire: **SCIAKY S.A. Société dite:**
**119 quai Jules Guesde**
**F-94400 Vitry sur Seine (Val de Marne) (FR)**

(72) Inventeur: **Dard, Philippe**
**4 Allée des Cèdres**
**Boussy Saint Antoine (Essonne) (FR)**

(74) Mandataire: **Cabinet Pierre HERRBURGER**
**115, Boulevard Haussmann**
**F-75008 Paris (FR)**

Courier Press, Leamington Spa, England.

## Description

L'invention concerne une installation pour le travail des métaux par faisceau d'électrons.

Cette technique donne lieu à des machines ou des installations qui comportent une enceinte de travail dans laquelle on réalise un certain niveau de vide et à laquelle est associé un générateur de faisceau d'électrons appelé canon à électrons.

Dans un tel canon, on extrait des électrons d'une surface émissive, on les accélère sous une tension élevée, de l'ordre de 100 ou 200 kilovolts, afin de leur donner une énergie appropriée puis on les concentre sur un point de la pièce que l'on désire traiter en vue de la fondre, de la percer, de la souder ou d'effectuer toute autre opération.

Ces différentes fonctions du canon, qui permettent d'obtenir un faisceau d'électrons concentré, doivent être exécutées sous un vide poussé, pour lequel les distances entre ses électrodes, en rapport avec ces potentiels qui leur sont appliqués, sont faibles. On obtient ainsi des canons à électrons compacts, que l'on peut introduire et déplacer dans les enceintes elles-mêmes.

L'alimentation de ces canons est obtenue par des ensembles transformateur/redresseur triphasés, hexaphasés ou dodecaphasés délivrant l'énergie, à la puissance et à la tension appropriées.

Le contrôle de la tension délivrée au canon s'effectue généralement par le primaire du transformateur/redresseur, de différentes façons selon le constructeur, par variostats électromécaniques, par régulateurs série à transistors ou à thyristors, etc.

Ces moyens, placés au primaire du transformateur, ont pour fonction d'assurer l'enclenchement de la puissance lorsqu'on désire produire le faisceau, le réglage et la régulation de la haute tension secondaire appliquée au canon en fonction des variations de la tension du réseau et de la charge ainsi que la mise hors circuit de l'ensemble lors d'un court-circuit secondaire.

Le taux d'ondulation naturel de la haute tension ainsi obtenu, dû à l'effet du redressement, est de 4% avec du redressement dodécaphasé et doit être réduit par un filtre inductance-capacité afin d'améliorer la qualité du faisceau.

Cependant, les canons utilisés pour le travail des métaux dans le vide fournissent la plupart du temps des faisceaux focalisés développant, à leur point de focalisation maximale, des puissances spécifiques très élevées. De telles puissances sont de nature à provoquer une vaporisation très rapide du matériau de la cible à travailler, c'est-à-dire à produire une masse gazeuse qui diffuse rapidement dans l'espace canon-pièce et dans l'espace interne au canon y créant un milieu ionisable par choc des électrons du faisceau.

L'ionisation, lorsque ses conditions sont réunies, provoque la naissance d'une décharge, voire d'un arc électrique, s'établissant entre canon et pièces, c'est-à-dire entre les deux polarités secondaires du générateur de haute tension appliquée au système. Cette décharge forme court-circuit entre les deux polarités secondaires du générateur avec comme conséquences essentielles la surcharge instantanée du générateur, des dommages aux électrodes et des cratères dans la pièce.

En général, les générateurs de haute tension d'alimentation des canons sont protégés contre les surcharges par des dispositifs sensibles qui, à partir de la mesure du courant délivré par le canon, actionnent un appareil de coupure disposé au primaire ou agissent sur les semi-conducteurs, transistors ou thyristors, de contrôle.

Malheureusement, ces systèmes ont un temps de réponse important par rapport à l'apparition des dommages aux électrodes et par rapport à la formation de cratères dans la pièce, ce qui peut être, dans le cas d'un soudage ou d'un traitement thermique, la cause de défauts irréductibles. En outre, ces dispositifs ne contrôlent pas la décharge de l'énergie accumulée dans le système sous forme électrostatique ou électromagnétique.

On connaît également par le brevet français No. 2 533 070 une installation à faisceau électronique pour le traitement électrothermique des métaux, comportant un canon à électrons dont l'anode est mise à la terre et dont la cathode est reliée à la polarité négative d'un ensemble transformateur-redresseur d'alimentation par l'intermédiaire d'un tube triode.

Dans ce cas, la polarité positive des redresseurs est reliée à la terre par un ensemble de selfs puis par un capteur de courant tandis qu'un capteur de courant ionique est placé dans le canon pour être sensible au flux d'ions quittant le métal traité.

Dans cette construction, les selfs qui sont mis à la terre ont pour but de protéger le tube triode contre les surtensions, tandis que le capteur de courant ionique a pour but de couper le courant de court-circuit qui pourrait s'établir.

A cet effet, le capteur de courant ionique, ainsi que le capteur de courant disposé entre les selfs et la terre, sont reliés à deux des entrées d'un comparateur recevant également les informations d'un capteur de tension branché sur l'anode du tube triode afin d'agir par l'intermédiaire d'un bloc de commande sur la grille de ce tube triode.

L'ensemble de ces dispositions a pour but d'augmenter la fiabilité de l'installation en cas de court-circuit en amenant ces courants de court-circuit à contourner le circuit d'alimentation.

On connaît également par le brevet français No. 2 456 384 un dispositif d'alimentation haute tension pour canon électronique de puissance et en particulier pour des évaporateurs.

Dans ce cas, l'ensemble transformateur-redresseur d'alimentation est relié directement à l'anode de l'évaporateur et à la terre, tandis que la polarité positive est reliée successivement par un filtre, un tube de commutation et un réjecteur comportant une bobine de réactance à la cathode de l'évaporateur.

Dans cette disposition, la bobine de réactance du réjecteur a pour but de supprimer les phénomènes de court-circuit lorsqu'ils se produisent et, dans la mesure où son action est insuffisante, le tube de commutation est bloqué avec un certain retard.

Suivant la demande de brevet en Grande-Bretagne No. 2 081 941, il est décrit un dispositif de commande de courant à boucle fermée pour un canon à électrons. Dans ce cas, la source d'alimentation haute tension est reliée par sa polarité positive à la terre et à la pièce à travailler, tandis que la polarité négative est reliée à la grille du canon.

Egalement, en parallèle sur cet ensemble d'alimentation, est prévu un pont diviseur qui détermine les potentiels de cathode et d'anode d'un tube triode dont l'anode est reliée, par un moyen sensible au courant, au filament de cathode du canon.

Dans cette construction, l'élément sensible au courant est relié en boucle fermée par l'intermédiaire de la grille du tube triode afin de réduire les variations de courant vers le filament.

La présente invention a pour but de pallier ces inconvénients en fournissant un moyen efficace d'éliminer complètement les décharges dans les machines à faisceau d'électrons, en évitant principalement les surintensités, les dommages aux électrodes et les défauts dans la pièce et, par suite, les arrêts fréquents des opérations.

Elle offre en outre un certain nombre d'avantages qui parquent un progrès important dans la technologie des machines à faisceau d'électrons et dans celle de l'alimentation des canons à savoir:

régulation très précise de la haute tension appliquée au canon avec un taux d'ondulation réduit (0,1%) et un temps de réponse extrêmement court,

suppression des effets de la fluctuation de haute tension, à la fréquence des ondulations de la haute tension redressée, sur la focalisation du faisceau d'électrons,

possibilité de moduler directement, par la haute tension, la puissance générée par le canon et ce à des fréquences élevées.

La présente invention permet en effet d'interrompre la haute tension appliquée à la cathode du canon puis de la rétablir dans un délai total très faible de moins de 2 milli-secondes, qui est le délai nécessaire à l'élimination complète, par diffusion dans l'espace, des vapeurs ayant causé l'ionisation, dès que celle-ci apparaît, c'est-à-dire dès que l'accroissement du courant qui en résulte dépasse un seuil réglable établi, par exemple, à + 10% du courant nominal. L'arrêt complet du faisceau, avant toute décharge, supprime toute possibilité de déformation de dommages aux électrodes. De plus, la coupure pendant 2 millisecondes du faisceau d'électrons n'est pas de nature à former de défauts dans la pièce.

La présente invention permet en outre de réaliser des générateurs sans limitation de puissance, c'est-à-dire susceptibles d'alimenter tous les canons à électrons existant actuellement.

Elle permet également de réguler la haute tension avec des taux d'ondulation très inférieurs à ceux existant dans la technique connue, et de fournir des faisceaux d'électrons de meilleures caractéristiques.

Elle offre également le moyen de moduler directement la puissance du faisceau.

L'invention concerne à cet effet une installation pour le travail des métaux par faisceau d'électrons, comportant un canon à électrons dont la cathode produit, dans une enceinte à vide, un faisceau d'électrons destiné à être focalisé sur la pièce à souder, un ensemble transformateur-redresseur produisant une haute tension redressée aux bornes du redresseur relié au secondaire du transformateur, ce redresseur étant relié par sa borne positive à l'anode du canon par l'intermédiaire de la terre constituant le potentiel de référence, et par sa borne négative à la cathode d'un tube à vide relié lui-même par son anode à la cathode du canon, des moyens sensibles au courant s'établissant dans le canon, ces moyens étant reliés à la grille du tube à vide pour interrompre le passage de ce courant lorsque son intensité dépasse une valeur déterminée, installation caractérisée en ce que les moyens sensibles au passage du courant sont disposés entre la polarité négative du redresseur et la cathode du tube à vide.

Suivant une autre caractéristique de l'invention, les moyens sensibles au courant sont reliés à la grille de commande du tube pour son blocage par l'intermédiaire d'un circuit de déclenchement à seuil et à faible constante de temps, et par l'intermédiaire d'un circuit de maintien de déclenchement agissant en cascade du circuit de déclenchement et prolongeant le blocage du tube pendant un temps réglable à l'aide de moyens de réglage.

Suivant une autre caractéristique de l'invention, le circuit de maintien de déclenchement est relié, pour sa commande, aux moyens sensibles au courant par une liaison à fibres optiques, une liaison à fibres optiques reliant également ce circuit au circuit de déclenchement pour sa commande.

Suivant une autre caractéristique de l'invention, les tubes à vide sont pourvus de moyens de refroidissement constitués par des radiateurs et des serpentins de circulation d'un fluide de refroidissement.

L'invention est représentée à titre d'exemples non limitatifs sur les dessins ci-joints dans lesquels:

la figure 1 est une vue latérale schématique de l'ensemble de l'installation,

la figure 2 est une vue latérale partielle et arrachée du mode de montage et de refroidissement des tubes tétrodes,

la figure 3 est le schéma électrique du circuit de déclenchement,

la figure 4 est le schéma électrique du circuit de maintien de déclenchement.

Cette installation comprend un canon 1 qui est mis sous vide par l'intermédiaire d'une tubulure 2 et qui comporte une cathode émissive 3 et une anode 4. La cathode 3 est reliée électriquement par un câble isolé 5 au générateur 6. Ce canon 1 est fixé sur l'enceinte métallique 7 mise sous vide par l'intermédiaire de la tubulure 8, cette enceinte 7 comportant une bobine focalisatrice 9 et contenant la pièce à travailler 10.

Le canon 1 produit, lorsqu'il est alimenté, le faisceau d'électrons 11 qui est focalisé en 12 sur la pièce 10 par la bobine 9.

Le corps du canon 1 est relié électriquement à l'enceinte métallique 7, elle-même reliée à la terre en 13 et à l'enveloppe 15 du générateur 6, elle-même à la terre en 14.

L'enveloppe 15 du générateur 6 est une enveloppe étanche remplie d'huile isolante et contient un transformateur polyphasé 17 alimenté en 18 par le réseau et équipé d'un pont de redresseur au silicium 19 délivrant une tension redressée dont la polarité positive est reliée en 14 à l'enveloppe 15, c'est-àdire à la terre. La polarité négative du pont redresseur 19 est reliée à une extrémité d'une résistance de mesure 21, elle-même reliée par son autre extrémité à la cathode 22 du tube à vide 23, constitué par une tétrode, et dont l'anode 27 est reliée au câble 5.

Comme cela sera expliqué ci-après, ce tube à vide est constitué en réalité par plusieurs tubes tétrodes disposés en parallèle.

A l'intérieur de l'enveloppe 15 du générateur 6, il est également prévu un circuit électronique 24 alimenté par un transformateur d'isolement 25. Ce circuit est relié en 26 aux bornes de la résistance de mesure 21 disposée en série entre le redresseur 19 et la cathode 22 du tube 23 afin que ce circuit 24 puisse recevoir une tension fonction de l'intensité du courant du faisceau électronique et agir sur la grille de commande 28 de ce tube afin de produire la coupure de sa conduction dès que l'intensité du courant s'écoulant au travers de la résistance 21, dépasse une valeur déterminée.

La tension apparaissant aux bornes de la résistance de mesure 21 agit également sur un émetteur opto-électronique 29 dont l'éclairage, fonction de la tension aux bornes de la résistance 21, est transmis par la fibre optique 30 à un capteur opto-électronique disposé à l'intérieur du circuit électronique 31. Comme on le verra ci-après, le circuit électronique 24 constitue un circuit de déclenchement pour le blocage du tube 23 lorsque le courant traversant la résistance 21 dépasse une valeur déterminée alors que le circuit 31 qui est extérieur à l'enveloppe 15 du générateur 6, a pour but de maintenir le blocage du tube 23, déclenché par le circuit 24, pendant un temps déterminé. A cet effet, le circuit 31 est relié à une entrée du circuit 24 par l'intermédiaire de la fibre optique 32 associée à ses émetteur et capteur opto-électroniques.

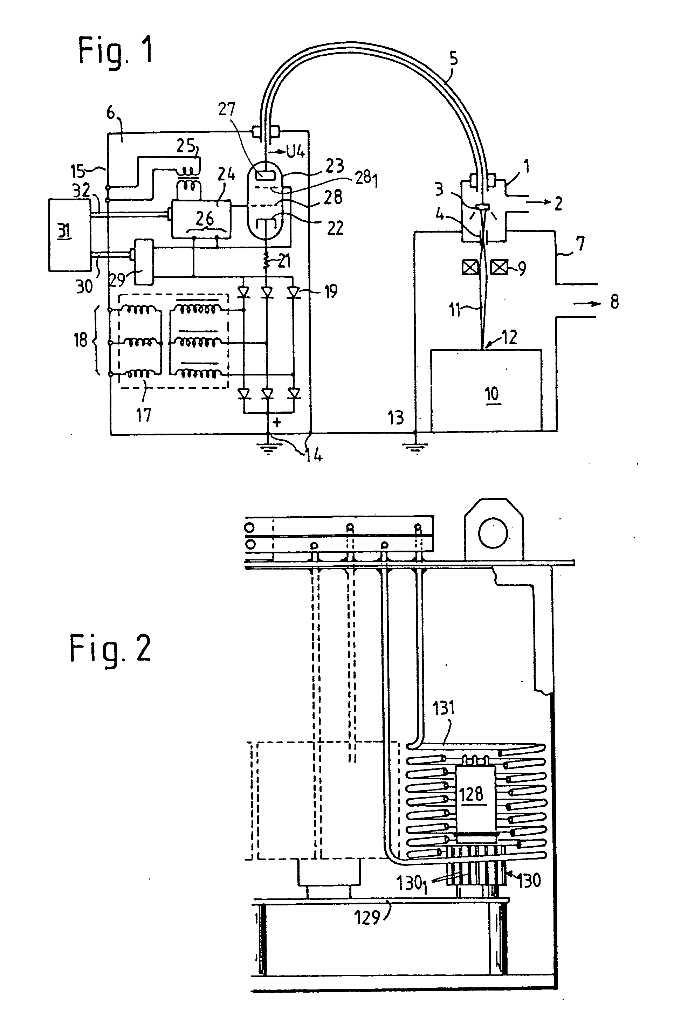

Sur le dessin de la figure 1, on n'a pas représenté les éléments auxiliaires tels que les circuits de chauffage des cathodes du tube 23, et du canon 1, les dispositifs de sécurité, etc.

Cette installation conforme à l'invention, permet d'obtenir des puissance disponibles importantes nécessaires pour tout type d'installation de travail des métaux par faisceau d'électrons et d'obtenir des coupures du faisceau d'électrons qui sont pratiquement instantanées étant donné que la coupure se produit entre la liaison de l'ensemble transformateur-redresseur 17—19 à la cathode 3 du canon, c'est-à-dire à hauteur du tube tétrode 23. En effet, dans cette construction, la liaison directe entre les enroule ments secondaires du transformateur 17 et le redresseur 19 avec la terre est maintenue lors de la coupure du circuit par la tétrode 23, ce qui supprime les effets de couplage capacitif et permet donc d'obtenir l'arrêt instantané du faisceau d'électrons. Suivant cette construction, il ne peut donc plus se produire de décharge par court-circuit à hauteur du canon ou de toute autre partie soumise à la haute tension, étant donné que lorsqu'il se produit un début d'ionisation, l'augmentation du courant qui en résulte est détectée par la résistance 21 qui provoque le blocage du tube 23.

Etant donné que l'on évite l'établissement de décharges dans la machine à faisceau d'électrons, on évite également les surintensités néfastes et, donc, l'endommagement de l'électrode ou l'apparition de défauts sur la pièce en cours de traitement.

Egalement, pour les mêmes raisons, cette installation permet de supprimer les arrêts fréquents de fonctionnement qui se produisent normalement en cas de surintensité.

Compte tenu de cette disposition, c'est-àdire de la mise en oeuvre du moyen de coupure (tétrode 23) entre la polarité négative du redresseur 19 et la cathode 3, on obtient une régulation très précise de la haute tension non seulement avec un temps de réponse extrêmement court mais également avec un taux d'ondulation réduit, avec comme conséquence une amélioration des caractéristiques du faisceau d'électrons et, notamment, de sa focalisation au point d'impact 12.

En effet, la coupure instantanée de la haute tension sur la cathode dès l'apparition d'une ionisation évite toute décharge par arc électrique avec tous les inconvénients qui en résultent et en permettant de rétablir le faisceau d'électrons au bout d'un temps bref, c'est-à-dire trop faible pour qu'il puisse apparaître des défauts dans la pièce 10 mais suffisant pour permettre la diffusion de l'ionisation apparue au point critique.

Pour mettre en évidence la puissance nominale importante disponible suivant l'invention, on considérera, à titre d'exemple, une installation comportant un canon de 30 kW fonctionnant sous une tension de 60 kV et qui présente les paramètres électriques suivants.

Le courant circulant entre le canon et le générateur est de 500 mA, le potentiel de la cathode par rapport à la terre est de 60 kV. Le potentiel de l'anode du tube tétrode 23 est également de 60 kV si l'on néglige la chute de tension dans le câble 5. La tension de travail de ce tube est de 4 kV et le potentiel de sa cathode 22 est de 64 kV par rapport à la terre qui est la tension en charge délivrée par l'ensemble transformateur-redresseur 17—19.

Dans ce cas, la puissance dissipée à 100% par le tube 23 est de 4 kV × 500 mA c'est-à-dire à 2 kW.

Sur la figure 1 ci-jointe, on n'a pas représenté, dans un but de simplification, l'électrode de commande de courant (Wehnelt). Cependant, cette électrode permet de régler le courant qui circule dans le circuit, c'est-à-dire dans l'exemple ci-dessus, de régler ce courant de 0 à 500 mA. Cette variation de charge donne lieu à une variation de la chute de tension dans le transformateur 17 et, par suite, à une variation de la tension d'accélération appliquée à la cathode 3 du canon.

De même, si la tension primaire appliquée au transformateur 17 varie de façon aléatoire, cette variation devrait se retrouver sur la tension de la cathode 3.

On comprendra cependant que du fait de la construction conforme à l'invention, cette tension d'accélération sera facilement maintenue constante par action automatique, expliquée par la suite, du circuit 24 sur la grille de commande 28 du tube tétrode 23.

L'action sur cette grille de commande 28 permet également de régler la tension de la cathode 3 dans toute la plage de 0 à 100%, c'est-à-dire dans l'exemple choisi ci-dessus, de 0 à 60 kV. Dans ce cas, la tension qui se développe entre cathode 3 et anode 4 du tube 23 varie en raison inverse et la puissance à dissiper à ce niveau s'accroît lorsque la tension appliquée à la cathode du canon diminue.

Le cas le plus défavorable de ce point de vue est obtenu lorsque la tension de la cathode 3 est de 40 kV, son débit maximal étant alors de 250 mA à cause de la pervéance du canon. La puissance dissipée par le tube 23 est alors, dans ce cas le plus défavorable, de 64 30 = 34 kV $\times$ 250 = 0,5 kW. Selon l'invention, on pourra donc mettre en oeuvre uniquement quatre tubes tétrodes en parallèle pour ce canon de 30 kW produisant une tension d'accélération de 60 kV, chacun de ces tubes tétrodes possédant une puissance nominale de 1 kW.

Pour permettre ce fonctionnement des tubes tétrodes, disposés en parallèle ou éventuellement en semi-parallèle, il sera cependant nécessaire d'assurer une dissipation calorifique importante sur ces tubes. A cet effet (voir figure 2) chaque tube tétrode 128 sera fixé sur une plaque de support 129 en métal bon conducteur de la chaleur et sera entouré à hauteur de son anode d'un manchon 130 également en métal bon conducteur de la chaleur et comportant des rainures $130_1$ sur sa périphérie afin de constituer un radiateur efficace. En outre, chaque tube tétrode 128 est entouré d'un serpentin 131 dans lequel circule un liquide de refroidissement.

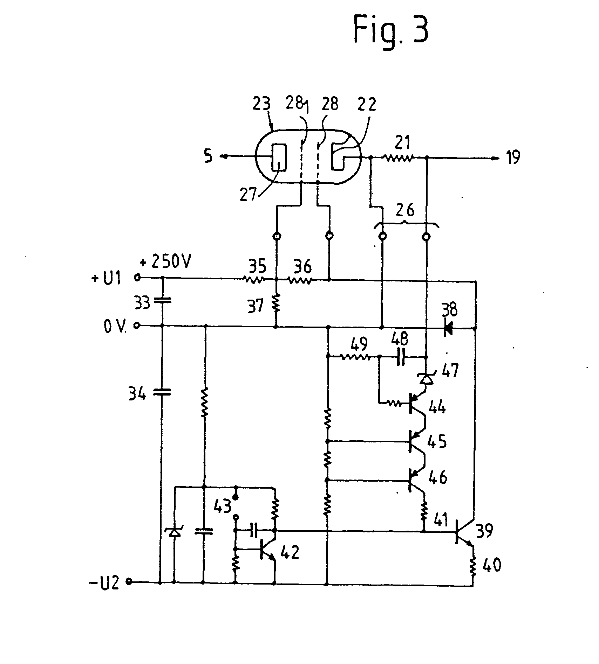

Le circuit de déclenchement 24 est représenté sur la figure 3, ce circuit ayant pour rôle d'une part, de réguler la haute tension appliquée à la cathode 3 du canon, d'autre part, d'assurer le blocage instantané du courant lors de la naissance d'une surintensité.

Ce circuit est alimenté par deux tensions U1 et U2 issues du transformateur d'isolement 26 et qui apparaissent aux bornes de deux condensateurs 33 et 34. Ces tensions sont, par exemple, de 250 Volts pour la tension U1 et de 600 Volts pour la tension U2.

Les résistances 35, 36 et 37 constituent un pont diviseur déterminant à partir de la tension U1 les potentiels des grilles 28 et $28_1$ et de la cathode 22 du tube tétrode 23 dont l'anode est reliée au conducteur 5 et dont la cathode est reliée à la polarité négative de l'ensemble redresseur 19 par l'intermédiaire de la résistance 21.

Le redresseur 38 associé au transistor 39 et à la résistance 40, permettent de régler la polarisation de la grille de commande 28 par rapport à la cathode 22 et par suite la différence de potentiel entre l'anode et la cathode de ce tube. Le courant de la base 41 du transistor 39 assurant le réglage de la conduction du tube 23, ou son blocage, par action sur la polarisation de la grille de commande 28, est déterminé tout d'abord, de façon permanente par le transistor 42 puis de manière instantanée à partir de la tension apparaissant aux bornes de la résistance 21 et par l'ouverture de trois transistors en cascade 44, 45 et 46. En effet, lorsque la tension aux bornes de la résistance 21 dépasse un seuil déterminé par la diode Zener 47, le transistor 44 devient passant et entraîne l'ouverture en cascade des transistors 45 et 46 avec pour effet de rendre complètement passant le transistor 39 et donc de polariser fortement la grille 28 par rapport à la cathode 22 et, par suite, d'interrompre la conduction du tube tétrode 23 et de couper instantanément le faisceau d'électrons.

La constante de temps de ce circuit déterminée par le condensateur 48 et la résistance 49 est très faible de façon à rétablir le fonctionnement normal du tube et du canon au bout d'un temps très faible de l'ordre de 20 microsecondes. Cependant, ce circuit 24 est également sous la dépendance du circuit 31 qui prolonge le blocage du tube 23 pendant un temps réglable. Ainsi, le circuit 24 n'a pour but que de régler la conduction du tube 23 et d'interrompre instantanément sa conduction dès qu'il apparaît une surintensité, alors que le circuit 31 a pour but de maintenir ce blocage de la conduction du tube 23 pendant un temps déterminé réglable.

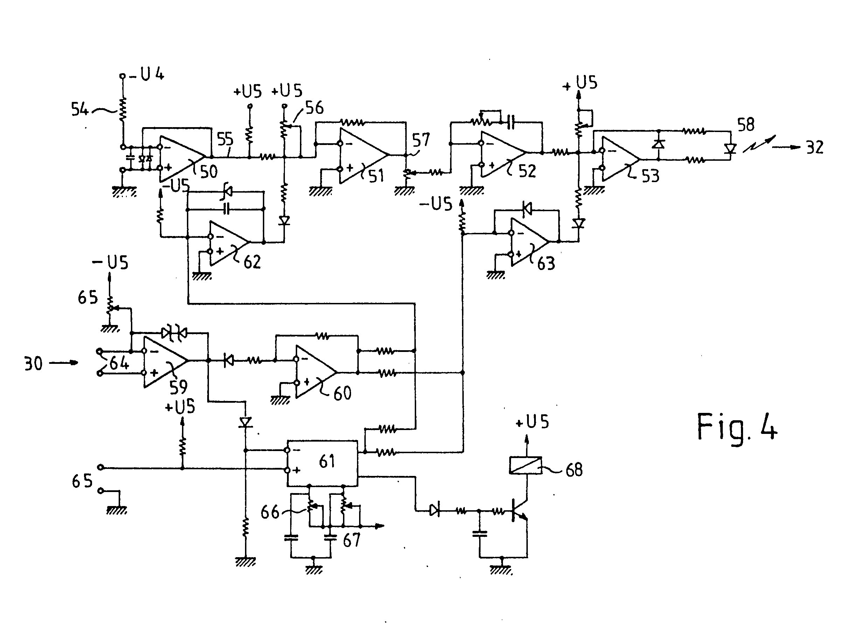

Le circuit 31 est représenté sur la figure 4.

Il reçoit sur ses bornes 64 une tension fonction de la tension apparaissant aux bornes de la résistance 21 et transmise par la fibre optique 30 et ses capteur et émetteur opto-électroniques. Il reçoit en outre une tension d'alimentation U4 fonction de la haute tension et prise sur l'anode du tube 23, ainsi qu'une tension de fonctionnement U5.

Il produit aux bornes de la diode électroluminescente 58 une information lumineuse qui est transmise par la fibre optique 32 et son capteur optoélectronique associé aux bornes 43 du circuit 24.

L'entrée du circuit 50 est placée en série avec la résistance 54 qui reçoit la tension d'alimentation -U4 et le circuit intégré 50 produit sur sa sortie 55 une basse tension image de la haute tension. Le circuit 51 compare la tension apparaissant en 55 avec la tension fournie par le potentiomètre 56 pour délivrer, en 57, une tension d'erreur.

Le circuit intégré 52 est un amplificateur intégrateur et le circuit intégré 53 est un amplificateur de puissance alimentant la diode électroluminescente 58 dont l'information est transmise aux bornes 43 par la fibre optique 32.

L'ensemble des circuits intégrés 50 à 53 forme donc une boucle de régulation de la haute tension ayant pour effet notamment de supprimer sur cette haute tension les ondulations résiduelles résultant de l'effet de redressement par les redresseurs 19.

Les circuits 59, 60, 61 ont pour objet de produire par l'intermédiaire des circuits 62 et 63, un signal de blocage sur la sortie 58 de manière à maintenir, par l'intermédiaire du transistor 42 du circuit 24, le blocage du tube tétrode 23 après l'apparition d'une surintensité traversant la résistance 21.

L'information fonction de la valeur du courant arrive par l'intermédiaire de la fibre optique 30 sur les bornes 64 tandis qu'une mesure de courant, par un potentiomètre 65 placé dans le circuit à la borne positive, est appliquée aux bornes du monostable 61.

Dès que le courant franchit le seuil réglé par le potentiomètre 65, le circuit 59 s'ouvre et bloque, par l'intermédiaire des circuits 60, 62 et 63 la boucle de tension. En conséquence, l'action du circuit 59 retardée par les temps de réponse des circuits par rapport à la réponse instantanée de la diode Zener 47 et du transistor 39, prolonge le blocage de ces derniers.

Le signal apparaissant en 65 fait également basculer en même temps le circuit monostable 61 dont l'effet est identique à celui du circuit 59 mais dont la durée est parfaitement contrôlée par les condensateurs 66, 67.

Le circuit 61 excite en outre le compteur 68 qui enregistre le nombre de blocages et qui engendre, au travers d'un circuit non représenté, un arrêt de l'installation en cas de répétition prolongée du phénomène de surintensité comme le ferait, par exemple, un court-circuit dans le canon.

A la fin de la temporisation déterminée par le monostable 61 et à condition que la surintensité du courant soit éliminée, les circuits reviennent au repos et la régulation de tension reprend son effet en appliquant instantanément la valeur de tension précédente.

L'arrêt total à la suite d'une surintensité est donc déclenché par le circuit 24 puis prolongé pendant une durée déterminée par le circuit 61 dans la mesure où cette surintensité résulte d'une ionisation n'ayant pas encore produit de court-circuit. Dans ce cas, en effet, la détection de cette surintensité produit instantanément par le circuit 24 la coupure du faisceau d'électrons, cette coupure étant maintenue par le circuit 61 pendant un temps suffisamment faible pour éviter l'apparition de défauts dans la pièce 10 à travailler mais suffisamment important pour que les vapeurs ionisées produites se dissipent.

## Revendications

1. Installation pour le travail des métaux par faisceau d'électrons, comportant un canon à électrons (1) dont la cathode (3) produit, dans une enceinte à vide, un faisceau d'électrons (11) destiné à être focalisé sur la pièce à souder (10), un ensemble transformateur-redresseur produisant une haute tension redressée aux bornes du redresseur (19) relié au secondaire du transformateur (17), ce redresseur (19) étant relié par sa borne positive à l'anode (4) du canon, par l'intermédiaire de la terre constituant le potentiel de référence, et par sa borne négative à la cathode d'un tube à vide (23) relié lui-même par son anode à la cathode (3) du canon, des moyens (21) sensibles au courant s'établissant dans le canon, ces moyens étant reliés à la grille du tube à vide pour interrompre le passage de ce courant lorsque son intensité dépasse une valeur déterminée, installation caractérisée en ce que les moyens (21) sensibles au passage du courant sont disposés entre la polarité négative du redresseur (19) et la cathode (22) du tube à vide.

2. Installation conforme à la revendication 1, caractérisée en ce que les moyens sensibles au courant sont reliés à la grille de commande (28) du tube (23) pour son blocage par l'intermédiaire d'un circuit de déclenchement (24) à seuil et à faible constante de temps (47, 48, 49), et par l'intermédiaire d'un circuit de maintien de déclenchement (31) agissant en cascade du circuit de déclenchement (24) et prolongeant le blocage du tube (23) pendant un temps réglable à l'aide de moyens de réglage.

3. Installation conforme à la revendication 2, caractérisée en ce que le circuit (31) de maintien de déclenchement est relié, pour sa commande, aux moyens (21) sensibles au courant par une liaison (30) à fibres optiques, une liaison à fibres optiques reliant également ce circuit au circuit de déclenchement (24) pour sa commande.

4. Installation conforme à l'une quelconque des revendications précédentes, caractérisée en ce que le tube à vide est constitué par plusieurs tubes tétrodes (23) disposés en parallèle.

5. Installation conforme à la revendication 4, caractérisée en ce que les tubes à vide sont pourvus de moyens de refroidissement constitués par des radiateurs (30) et des serpentins (31) de circulation d'un fluide de refroidissement.

6. Installation conforme à la revendication 2, caractérisée en ce que la grille de commande (28) du tube (23) est commandée, pour son blocage, par l'intermédiaire d'un transistor (39) recevant également sur sa base, en fonctionnement normal, une information fonction de la valeur de la haute tension (U4) pour sa régulation.

## Patentansprüche

1. Elektronenstrahlinstallation zur Metallbearbeitung mittels Elektronenbündel, aufweisend eine Elektronenkanone (1), deren Kathode (3) in einer Vakuumkammer ein Elektronenbündel (11) erzeugt, welches dazu bestimmt ist, auf ein zu lötendes Stück (10) gerichtet zu werden, mit einer eine gleichgerichtete Hochspannung an den Polen des mit der Sekundärseite des Transformators (17) verbundenen Gleichrichters (19) erzeugende Transformator-Gleichrichter-Einheit, wobei dieser Gleichrichter (19) vermittels der das Referenzpotential bildenden Erde mit der Anode (4) der Kanone verbunden ist und mit seinem negativen Pol mit der Kathode einer Vakuumröhre (23) verbunden ist, welche wiederum mit ihrer Anode mit der Kathode (3) der Kanone verbunden ist, weiter mit auf den Strom in der Kanone empflindlichen Mittel (21), wobei diese Mittel mit dem Gitter der Vakuumröhre verbunden sind, um den Stromdurchgang zu unterbrechen, wenn seine Intensität einen bestimmten Wert überschreitet, dadurch gekennzeichnet, daß die stromempfindlichen Mittel (21) zwischen der negativen Polarität des Gleichrichters (19) und der Kathode (22) der Vakuumröhre angeordnet sind.

2. Installation nach Anspruch 1, dadurch gekennzeichnet, daß die stromempfindlichen Mittel mit dem Steuergitter (28) der Röhre (23) verbunden sind, um dieses zu sperren mittels eines Zündschaltkreises (24) geringer Zeitkonstante (47, 48, 49) und mittels eines die Zündung aufrechterhaltenden Kreises (31), der als Kaskadenschaltung (24) die Sperrung der Röhre (23) verlängert, während einer mit Hilfe von Einstellmitteln einstellbaren Zeit.

3. Installation nach Anspruch 2, dadurch gekennzeichnet, daß der die Zündung aufrechterhaltende Kreis zur Steuerung mit den stromempfindlichen Mitteln verbunden ist durch eine optische Faserverbindung (30), wobei eine optische Faserverbindung in gleicher Weise diesen Kreis mit dem Zündkreis (24) zur Steuerung verbindet.

4. Installation nach einem der vorangehenden Ansprüche, dadurch gekennzeichnet, daß die Vakuumröhre als mehrere parallel angeordnete Tettroden (23) ausgebildet ist.

5. Installation nach Anspruch 4, dadurch gekennzeichnet, daß für die Vakuumröhre Kühlmittel bestehend aus Kühlkörpern (30) und aus Schlangen (31) eines Kühlflüssigkeitskreislaufes vorgesehen sind.

6. Installation nach Anspruch 2, dadurch gekennzeichnet, daß das Steuergitter (28) der Röhre (23) zur Sperrung von einem Transitor (39), der in gleicher Weise bei normaler Funktion über seine Basis eine Funktionsinformation über den Wert der Hochspannung für deren Steuerung erhält, gesteuert ist.

## Claims

1. Installation for working metals using an electron beam, comprising an electron gun (1) whose cathode (3) produces, in a vacuum chamber, an electron beam (11) intended to be focussed on the piece (10) to be welded, a transformer/rectifier assembly producing a high voltage which is rectified at the terminals of the rectifier (19) connected to the secondary winding of the transformer (17), this rectifier (19) being connected, by its positive terminal, to the anode (4) of the gun by means of the earth constituting the reference potential, and via its negative terminal to the cathode of a vacuum tube (23) which is itself connected, via its anode, to the cathode (3) of the gun, current-sensitive means (21) being established in the gun, these means being connected to the grid of the vacuum tube in order to interrupt the passage of this current when its intensity exceeds a specific value, which installation is characterized in that the means (21) which are sensitive to the passage of the current are disposed between the negative pole of the rectifier (19) and the cathode (22) of the vacuum tube.

2. Installation according to Claim 1, characterized in that the current-sensitive means are connected to the controls grid (28) of the tube (22) for the blocking thereof by means of a threshold trigger circuit (24) with a low time constant (47, 48, 49), and by means of a trigger maintenance circuit (31) acting in cascade with the trigger circuit (24) and prolonging the blocking of the tube (22) for a time which may be regulated with the aid of regulating means.

3. Installation according to Claim 2, characterized in that the trigger maintenance circuit (31) is connected, for control thereof, to the current-sensitive means (21) via an optical-fibre link (30), an optical fibre link likewise connecting this circuit to the trigger circuit (24) for control thereof.

4. Installation according to any one of the preceding claims, characterized in that the vacuum tube consists of several tetrode tubes (23) disposed in parallel.

5. Installation according to Claim 4, characterized in that the vacuum tubes are provided with cooling means consisting of radiators (30) and pipe coils (31) for circulation of a cooling fluid.

6. Installation according to Claim 2, characterized in that the control grid (28) of the tube (23) is controlled, for blocking thereof, by means of a transistor (39) likewise receiving on its base, during normal operation, information which is a function of the value of the high voltage (U4) for regulation thereof.

# Fig. 1

# Fig. 2

# Fig. 3

Fig. 4

EP 0 159 214 B1